# EUROPEAN PATENT APPLICATION

(11) **EP 1 199 748 A1**
(43) Date of publication of application: **24.04.2002**
(21) Application number: 00122605.9
(22) Date of filing: 17.10.2000
(51) Int. Cl.: H01L 23/467, H01L 23/367

(54) **Improved heat dissipater structure**

(71) Applicant: Wei, Wen-Chen, Taipei Hsien (TW)
(72) Inventor: Wei, Wen-Chen, Taipei Hsien (TW)
(74) Representative: Zeitler, Giselher, Dipl.-Ing.

(57) **Abstract**

An improved heat dissipation structure, is mainly comprised of a heat dissipation base with multiple heat dissipation poles individually folded upwards from the four sides of the said heat dissipation base, with a receiving slot space formed at the center and, at the bottom section, a plane bottomed heat absorbing plate; the rectangular heat dissipation poles staggering fore and aft in row arrangement significantly increase the contact area on the surfaces of the heat dissipation poles with the air to enhance the heat dissipation efficiency from the heat absorbing plate at the bottom section; as needed, the receiving slot can stack more heat dissipation bases with smaller volumes to adjust to the needs of different levels of heat dissipation and to achieve the maximum heat dissipation efficiency.

## Description

### BACKGROUND OF THE INVENTION

### 1) FIELD OF THE INVENTION

The invention herein relates to an improved heat dissipater structure, more specially a heat dissipation base with multiple long heat dissipation poles formed by folding the four sides upwards along the heat dissipation base, staggering fore and aft, greatly increases the contact area of the surfaces of heat dissipation poles and the air and, furthermore, the receiving slot on the heat absorbing plate can stack more heat dissipation bases for adjusting to the needs of different levels of heat dissipation.

### 2) DESCRIPTION OF THE PRIOR ART

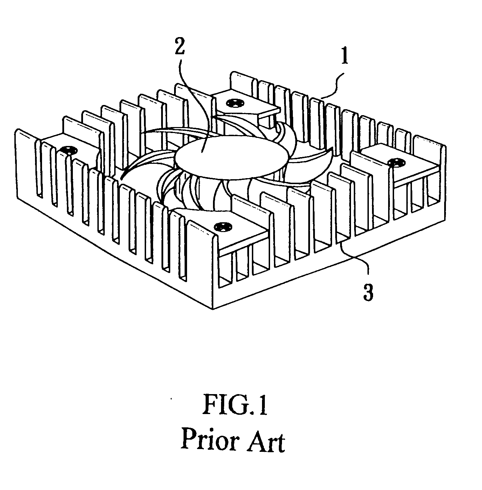

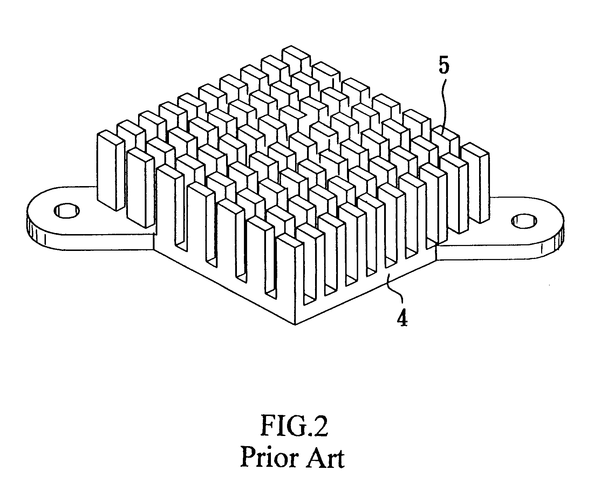

As is widely known, in order to solve the overheating problem inside the computer central processing unit, a heat dissipater device is usually added to the heat sources, such as the IC components, the power chips and the power supply module, thereby enabling the high temperature produced by the electric components to be conducted by the heat dissipater device. However, conventional heat dissipater devices currently available, as indicated in FIG. 1, are comprised of a fan(2) added to the concaved receiving-space formed at the center of the heat sink element(1), wherein the four sides of the heat sink element(1) have grooved intervals as the hot air outlets(3). After being installed on the surface of electric heat generating components, the fan starts to turn and induct the outside cool air to blow on the heat sink elements to diffuse the updraft heat from the electric components through the hot air outlets (3) and thereby achieve heat dissipation capability. However, the fan (2) on this type of heat dissipation device is a heat source itself, therefore the heat source usually cumulates between the heat sink elements (1) and the fan (2) to form a standstill layer and that consumes the fan power without increasing the heat dissipation capability and furthermore, the fan is electric operated and breaks down easily resulting in affecting the stability of the heat dissipation device. Therefore, most of the industries shift to another heat dissipation device with a natural way of diffusion which, as indicated in FIG. 2, is comprised of the heat sink fins (5) installed on the base plate (4) on the heat dissipation device, wherein the base plate (4) firmly pressing against the electric heat generating components and thereby the high temperature produced by the electric components during operation is conveyed through the heat sink fins (5). Although this type of heat sink dissipater is electricity free and endurable, the finishing process is procedurally complicated and not only is fabrication time consuming, but also production costs are higher for first shaving the heat sink fins (5) into long fin-shapes, then cutting them into fin-blocks with equal interval distance which involving considerable material consumption losses and furthermore, since the strip rib and the edge frame are thicker, the heat accumulates more and the conduction speed is slower, which limits the heat dissipation efficiency and becoming inadequate for the electric heat generating elements that requiring fast speed and long execution time.

In view of the various shortcomings of conventional heat dissipation devices, the inventor of the invention herein, based on expertise and experience, addressed the said shortcomings by researching solutions for improvement and innovation which, culminated in the development of the improved heat dissipation device structure.

### SUMMARY OF THE INVENTION

Specifically, the improved heat dissipation device structure of the invention
herein consists of a heat dissipation base with multiple heat dissipation poles formed by cutting and folding the four sides upwards along the heat dissipation base to make the center surface a receiving space slot and the bottom a plane bottomed heat absorbing plate, wherein the multiple heat dissipation poles are vertical and rectangular, staggering fore and aft in row arrangement, the number of poles in the outer rows is larger than that of the inner ones to reduce the reverse flow interference to make the air convection quickly and smoothly; furthermore, by punch press, not only produces larger number of poles and saves more materials than the conventional devices do, but also lowers the production costs; furthermore, the vertical and rectangular heat dissipation poles folded upwards directly from the heat dissipation base diffuse the heat faster and, the contact area with the air is larger than that of the conventional devices and accelerates the heat dissipation efficiency from the heat absorbing plate at the bottom section; furthermore, as needed, the space at the receiving slot can stack more heat dissipation bases with the same type but smaller volumes to form a compact air current heat dissipation net and to effectively increase the heat dissipation area to meet the needs of different levels of heat dissipation, thereby to achieve the maximum operation efficiency of the heat dissipation device and efficiency of heat dissipation and, furthermore, precisely solve the overheating problem of the computer components.

Therefore, the primary objective of the invention herein is to provide an improved heat dissipation structure, wherein the multiple heat dissipation poles are formed by folding individually the four sides of the heat dissipation base upwards; the rectangular heat dissipation poles, staggering each other fore and aft in row arrangement, greatly increase the contact area of the surfaces on the heat dissipation poles with the air, accelerate the heat dissipation efficiency.

Another objective of the invention herein is to provide an improved heat dissipation structure, wherein a receiving slot formed on the surface of the heat absorbing plate at the center of the heat dissipation base can stack more heat dissipation bases with smaller volumes to meet the needs of different levels of heat dissipation for achieving the maximum heat dissipation efficiency.

Another objective of the invention herein is to provide an improved heat dissipation structure, wherein the multiple heat dissipation poles formed by directly cutting and folding the four sides of the heat dissipation base requiring less labor time in production, less materials and lowering production costs.

Another objective of the invention herein is to provide an improved heat dissipation structure, wherein the receiving slot formed at the center of the heat dissipation base can stack more heat dissipation bases with smaller volumes for utilizing the smallest volume to increase the optimal heat dissipation surface area.

To enable a further understanding of the said objectives, the technological methods, and specific structural features of the invention herein, the brief description of the drawings below is followed by the detail description for additional elaboration.

Figure 1 is a pictorial drawing of a conventional heat dissipation device.

Figure 2 is a pictorial drawing of another conventional heat dissipation device.

Figure 3 is a pictorial drawing of the invention herein.

Figure 4 is a plane spread drawing of the invention herein before cutting.

Figure 5 is an isometric pictorial drawing of the invention herein in application.

Figure 6 is an isometric pictorial drawing of the invention herein in assembly application.

### DETAILED DESCRIPTION OF THE INVENTION

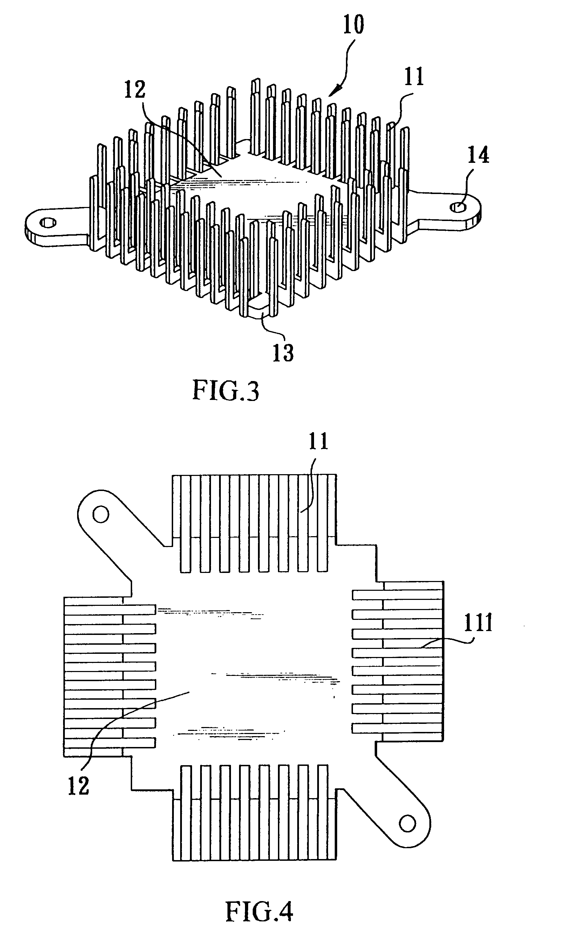

Referring to FIG. 3, the pictorial drawing of the invention herein, mainly the four sides of the said heat dissipation base (10) are cut individually and folded directly upwards to form multiple heat dissipation poles (11), a receiving slot at the center and a heat absorbing plate (13) at the bottom section with mounting holes (14) protruding from the two diagonal ends to be fastened with screws to the electric heat generating components of the computer, wherein, the heat dissipation poles (11) are vertical and rectangular poles, enabling the four long and tall side surfaces to contact the air and thereby greatly increase the contact area with the air, and augment the heat diffusion capability; the heat dissipation poles (11) stagger each other fore and aft in row arrangement, while the number of poles in the outer rows larger than that of the inner ones to reduce the reverse flow interference, and enable the air convection to flow quickly and smoothly; furthermore, the long and narrow rectangular poles conduct the heat very fast, therefore, accelerate the heat dissipation efficiency from the absorbing plate (13) at the bottom section; the center of the receiving slot (12) has space for stacking more heat dissipation bases with same type but smaller volume to adjust to the needs of different levels of heat dissipation; the heat absorbing plate (13) has plane bottom pressed firmly to the electric heat generating components to absorb the maximum heat source.

Referring to FIG. 4, the plane spread drawing of the invention herein before cutting, the said heat dissipation structure is a cruciform plate before punch press, when pressed, one only needs to cut along the preset cutting lines (111) and simultaneously fold upwards to form the heat dissipation poles staggering fore and aft in row arrangement; to accomplishing the said invention in one punch press without wasting any materials or requiring any additional process results in saving the labor time, materials and lowering the production costs.

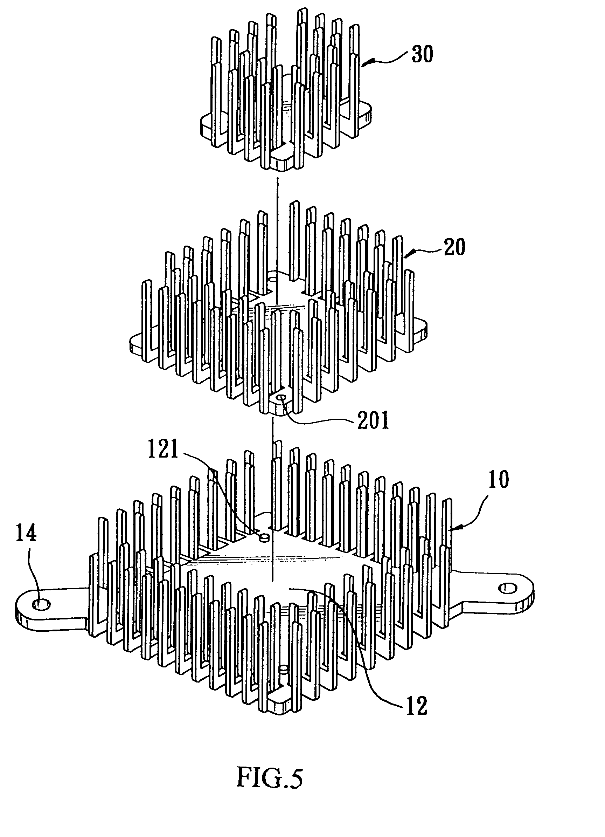

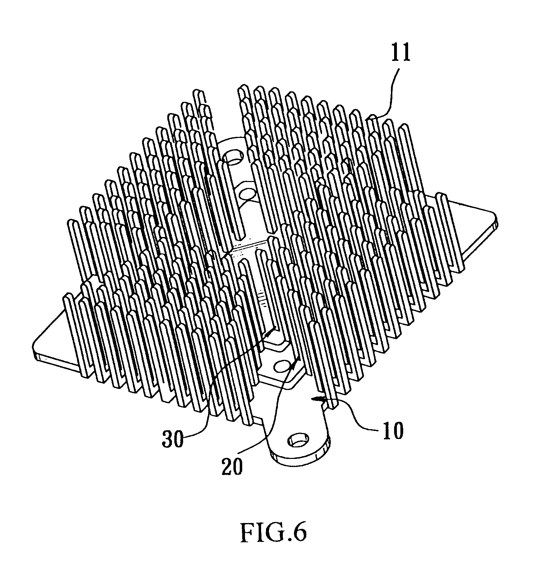

Referring to the FIGs 5 and 6, the isometric pictorial drawings of the invention herein in application and in assembly application, as the electric heat generating components require faster heat dissipation, one only needs to stack the second heat dissipation base (20) with the same type but smaller volume to the receiving slot on the heat dissipation base (10), thereby significantly increase the contact area with the air and augment the heat dissipation capacity; the assembly can be finished either by gluing or sticking or by drilling extra mounting holes (201) on the two diagonal ends of the second heat dissipation base (20) to be fastened by interlocking with the additional mounting bar (121) on the heat dissipation base (10); furthermore, due to the higher temperature produced by the heat source or the needs for faster heat dissipation efficiency, stack the third, even smaller heat dissipation base (30) to the receiving slot (22) on the second heat dissipation base (20) to form the assembly shown in FIG. 6; since the heat dissipation poles (11) staggering fore and aft in row arrangement, and the number of the poles in the outer rows is larger than that of the inner ones, therefore, after the assembly of stacking the heat dissipation base (10), the second heat dissipation base (20) and the third heat dissipation base (30), the row arrangement of the four sides of the heat dissipation poles displays triangle-inverted shapes, thereby not only greatly enhances the heat dissipation area and accelerates the rate of heat dissipation, but also cooperates with the intervals among the heat dissipation poles (11) to enable the air convection more smoothly, and relatively to accelerate the rate of the flow speed of the air current, thereby, diffuses the heat energy continuously and quickly.

However, the terminology utilized for the said drawings and components have been selected to facilitate the description of the invention herein and shall not be construed as a limitation on the patented scope and claims of the invention herein and, furthermore, all substitutions of equivalent components by persons killed in the relevant technology based on the spirit of the invention herein shall still be regarded as within the protected scope and claims of the new patent rights granted the invention herein.

In summation of the foregoing section, the improved "Heat Dissipation Structure" is an invention of reasonable perfection that not only possesses outstanding practicality, but has an unprecedented structural spatial design that is original and innovative and, manifestly accelerates the rate of heat dissipation and enhances the heat dissipation efficiency, is a solution to the height characteristics of inventions based on the conventional technology and, furthermore, is progressive and not a conception based merely on familiarity of utilization; therefore, the invention herein fully complies with all new patent application requirements and hereby sincerely submitted to the patent bureau for review and the grating of the commensurate patent rights.

## Claims

1. An improved heat dissipation structure mainly comprised of a heat dissipation
base in the shape of a square slot object with four sides cut and folded to form multiple heat dissipation poles with a receiving slot at the center and a plane-bottomed heat absorbing plate at the bottom section of the said heat dissipation base, and the innovations are:
directly cutting and folding upwards along the heat dissipation base are rectangular, vertical and multiple heat dissipation poles staggering fore and aft in row arrangement with the larger number of poles in the outer rows than that in the inner ones.

2. As mentioned in Claim 1 of the improved heat dissipation structure invention herein, the said receiving slot has a receiving space for stacking more heat dissipation bases with smaller volume as needed.

3. As mentioned in Claim 2 of the improved heat dissipation structure invention herein, on the final said receiving slot, the mounting bars can be set for interlocking the heat dissipation base with smaller volume.
